# EUROPÄISCHE PATENTANMELDUNG

(11) **EP 0 568 715 A1**
(43) Veröffentlichungstag der Anmeldung: **10.11.1993**
(21) Anmeldenummer: 92107616.2
(22) Anmeldetag: 06.05.1992
(51) Int. Cl.: H01L 23/498, H01L 23/485

(54) **Schaltungsplatte**

(71) Anmelder: Keesmann, Till, D-69115 Heidelberg (DE)
(72) Erfinder: Keesmann, Till, D-69115 Heidelberg (DE)
(74) Vertreter: Clemens, Gerhard, Dr.-Ing.

(57) **Zusammenfassung**

Das Schaltungsbild eines Chip weist elektrisch leitfähige Fullerene auf.

## Beschreibung

Die Erfindung betrifft eine Schaltungsplatte mit einem isolierenden Träger, auf den ein Schaltungsbild aus elektrisch leitendem Material, zum Beispiel Metall, leitfähigen Polymeren, leitfähigen Polymerabkömmlingen, leitfähigen Kunststoffen, leitfähiger oder superleitfähiger Keramik, aufgetragen ist, gemeinhin auch Chip genannt.

Aufgabe der Erfindung ist es, eine Schaltungsplatte der eingangs genannten Art so auszugestalten, daß durch unterschiedliche Dotierung eine möglichst vielfältige, unterschiedliche Qualität der elektrischen Eigenschaften regional erzielbar ist, um auf diese Weise bei der Gestaltung der Schaltungen und der Schaltungselemente weitere Möglichkeiten zur Differenzierung und Miniaturisierung zu gewinnen.

Die Erfindung löst diese Aufgabe dadurch, daß das Schaltungsbild elektrisch leitfähige Fullerene aufweist.

Unter Fullerenen werden sogenannte Käfigmoleküle aus sphärisch angeordneten C-Atomen verstanden, vorzugsweise mit der chemischen Summenformel C₂ₙ, wobei sich n = 30, also die Summenformel C₆₀ besonders bewährt hat.

Sie nutzt dabei die besonderen elektrischen Eigenschaften dotierter Fullerene aus und die Tatsache, daß diese elektrischen Eigenschaften durch unterschiedliche Dotierung mit großer Mannigfaltigkeit variierbar sind.

Der Ausdruck Dotierung wird hier und im folgenden in sehr weiter Auslegung gebraucht. Er schließt ein die Anlagerung und/oder die Einlagerung fremder Moleküle und auch den Austausch einiger Kohlenstoffmoleküle durch Dotierungsmoleküle.

Für ein dotiertes Fullerenmolekül ergibt sich die Summenformel XᵣC₂ₙ
mit X = H, Li, Na, K, Rb, Cs und/oder Fr
mit r = 0, 1, 2 ..., vorzugsweise 1
mit n = 16, 17, 18 ..., vorzugsweise 30.
Die Fremdatome X sind dem Fulleren durch Dotierung, Einlagerung, Anlagerung und/oder Beimischung zugefügt. Ein dotiertes Fulleren mit der Summenformel K₃C₆₀ ist besonders bevorzugt.

Das ganze Schaltungsbild kann aus elektrisch leitenden Fullerenen gebildet sein, wobei durch unterschiedliche Dotierung leitfähig gemachte Fullerene und Fullerene unterschiedlichen elektrischen Eigenschaften eingesetzt sein können. Es können aber auch nur Teile des Schaltungsbildes aus elektrisch leitenden Fullerenen gebildet sein und die übrigen konventionell aus Halbleiter- oder Leitermaterial.

Man kann die Fullerene unterschiedlich auftragen, zum Beispiel mit Hilfe von Laser. Vorteilhaft ist elektrolytischer Auftrag, weil er einfach zu handhaben ist und den Auftrag der Käfigmoleküle leicht steuerbar macht, beispielsweise durch elektrische Felder.

Das Schaltungsbild kann Widerstände, Kondensatoren, Dioden, Transistoren und/oder dergleichen elektrische Schaltungselemente integriert aufweisen, die ganz oder teilweise durch leitfähige Fullerene gebildet sind.

Vorzugsweise sind im Interesse einer hohen Miniaturisierung die das Schaltungsbild bildenden Fullerene in ein oder mehreren monomolekularen Schichten aufgetragen und Zwischenschichten anderer Leitfähigkeit als die der Fulleren-Schicht zwischen benachbarten Fulleren-Schichten vorgesehen, so daß sich ein Schichtenaufbau ergibt, wie er auch konventionellen Chips zugrundeliegt.

Bei der Herstellung geht man zweckmäßig so vor, daß man eine monomolekulare Schicht zunächst einmal aufträgt, und zwar nach einem bestimmten, durch die Schaltung vorgegebenen Muster. Zur Herstellung der monomolekularen Schicht werden die Fullerene vorzugsweise auf die Kristallflächen eines Halbleiters, vorzugsweise Galliumarsenid, Gallium-Aluminiumarsenid, Aluminium-Galliumarsenid, Indiumphosphid oder Indiumgalliumarsenid, aufgewachsen. Aufgrund des Musters können Lücken in der Fulleren-Schicht entstehen, es können aber auch Felder unterschiedlicher Dotierung entstehen. Die Lücken können zunächst mit Fullerenen ausgefüllt sein, die dann abgetragen werden, zum Beispiel durch Ausätzen. Die Dotierung kann zunächst einheitlich sein, sie kann dann nach dem Schaltungsbild umdotiert werden. Diese Maßnahmen, die nach dem Schaltungsbild erfolgen und lokal wirksam sind, kann man, wie auch bei den bekannten Chips, fotoelektrisch steuern.

Die Zwischenschichten bestehen vorzugsweise aus Halbleitermaterial und gestatten es, mehrschichtige Schaltungselemente, wie Zum Beispiel Transistoren, aufzubauen, die dann in die übrige Schaltung integriert sind. Wenn die Zwischenschichten aus Isoliermaterial bestehen, können auch auf verschiedenen Ebenen Leitungen vorgesehen sein.

Innerhalb einer monomolekularen Schicht sind die Fullerenmoleküle vorzugsweise gleichgroß aber entsprechend dem angestrebten Schaltungsbild unterschiedlich dotiert.

Die elektrischen Eigenschaften der Fullerenmoleküle in einer monomolekularen Schicht werden auch bestimmt durch die sphärische Anordnung der Dotierungsmoleküle, so daß bei Einsatz gleicher Dotierungsmoleküle, die sphärisch unterschiedlich angeordnet sind, unterschiedliche elektrische Leitungscharakteristika zu erzielen sind. Das läßt sich mit der Erfindung nutzen und vergrößert die mit der Erfindung angestrebte Mannigfaltigkeit.

Eine dementsprechende bevorzugte Ausgestaltung ist dadurch gekennzeichnet, daß benachbart angeordnete, eine Gruppe bildende Fullerene hinsichtlich ihrer Dotierung mit gleicher sphärischer Orientierung aber gegenüber Fullerenen anderer Gruppen mit unterschiedlicher sphärischer Orientierung angeordnet sind.

Eine weitere, dementsprechende bevorzugte Ausgestaltung ist dadurch gekennzeichnet, daß Fullerene in mehrere Gruppen unterteilt sind, daß die Fullerene der einzelnen Gruppen gemischt, ein Raster bildend angeordnet sind, daß die Fullerene einer Gruppe unter sich gleichgroß, gleichdotiert und mit Bezug auf ihre Dotierung sphärisch gleich orientiert angeordnet sind und daß die Fullerene unterschiedlicher Gruppen sich hinsichtlich Größe, Dotierung, sphärischer Anordnung und/oder ihrer Anordnung inverschiedenen Ebenen voneinander unterscheiden.

In der Zeichnung ist ein Ausführungsbeispiel einer Schaltungsplatte dargestellt, und zwar zeigt
- Figur 1: ausschnittsweise den Querschnitt,
- Figur 2: die Draufsicht gemäß dem Pfeil II aus Figur 1 und
- Figur 3: eine Tabelle.

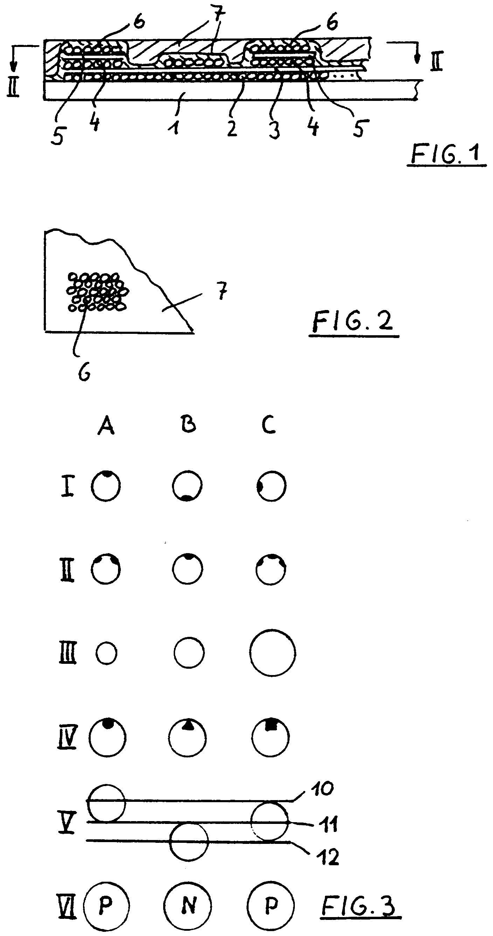

In Figur 1 ist mit 1 ein Isolierträger, mit 2 eine erste monomolekulare Fulleren-Schicht, mit 3 eine erste unterbrochene Zwischenschicht, mit 4 eine unterbrochene zweite monomolekulare Fulleren-Schicht, mit 5 eine unterbrochene zweite Zwischenschicht und mit 6 eine unterbrochene dritte monomolekulare Fulleren-Schicht bezeichnet. Außerdem ist die ganze Oberseite durch eine aufgegossene Schutzschicht 7 aus isolierendem Kunststoff geschützt.

Die Fullerene sind entsprechend dem angestrebten Schaltungsbild unterschiedlich dotiert und bilden mit oder ohne Zwischenschichten die angestrebte Schaltung, also nicht nur die Leitungen der Schaltung, sondern auch Schaltungselemente wie Widerstände, Kondensatoren, Dioden, Transistoren und dergleichen, die zu dieser Schaltung gehören.

Einzelne Fullerenmoleküle sind durch Dotierung leitfähig gemacht. Das kann auf unterschiedliche Weise geschehen. Einige bevorzugte Ausgestaltungen werden jetzt anhand der Figur 3 erläutert.

Benachbart im Schaltungsbild angeordnete Fullerene können eine Gruppe bilden. Auf diese Weise können mehrere Gruppen von Fullerenen vorgesehen sein. Innerhalb der einzelnen Gruppen sind die Fullerene hinsichtlich ihrer Dotierung und/oder ihrer sonstigen Kriterien, die anhand der Figur 3 abgehandelt werden, gleich angeordnet, aber von Gruppe zu Gruppe unter Umständen unterschiedlich.

Die Möglichkeiten der Anordnung und Ausgestaltung aufgrund der Dotierung und sonstiger Kriterien werden nun anhand der Figur 3 erläutert.

In Zeile I aus Figur 3 sind drei unter sich gleiche und gleichdotierte Fullerenmoleküle angezeigt, die sich jedoch hinsichtlich ihrer durch einen schwarzen Punkt gekennzeichneten Dotierung in ihrer sphärischen Anordnung unterscheiden.

In Zeile II sind drei unter sich gleiche Fullerenmoleküle dargestellt, die jedoch unterschiedlich dotiert sind; das eine Molekül mit einem Dotierungselement, das nächste mit zwei Dotierungselementen und das letzte mit drei Dotierungselementen.

In Zeile III sind Fullerenmoleküle dargestellt, die sich durch ihre Größe unterscheiden.

In Zeile IV sind Fullerenmoleküle dargestellt, die sich durch die Art der eingesetzten Dotierung unterscheiden, was zeichnerisch zum Ausdruck gebracht ist, indem die Dotierung einmal durch einen Kreis, einmal durch ein Dreieck und einmal durch ein Viereck dargestellt ist.

In Zeile V sind identische Fullerenmoleküle dargestellt, die jedoch in unterschiedlichen Ebenen 10, 11, 12 angeordnet sind, wobei die beiden außen gelegenen Ebenen 10 und 12 einen Abstand inder Größenordnung des Durchmessers eines Fullerenmoleküls aufweisen.

In Zeile VI sind die Fullerenmoleküle mit dem Leitfähigkeitstyp p, n und p dotiert.

Die Einsatzmöglichkeiten sind entsprechend wie die bei bekannten Chips, jedoch sind bessere Miniaturisierungen und Vielfältigkeiten erzielbar.

## Patentansprüche

1. Schaltungsplatte mit einem isolierenden Träger, auf den ein Schaltungsbild aus elektrisch leitendem Material aufgetragen ist, dadurch gekennzeichnet,
daß das Schaltungsbild elektrisch leitfähige Fullerene ( 2 ) aufweist.

2. Schaltungsplatte nach Anspruch 1, dadurch gekennzeichnet,
daß das Schaltungsbild oder Teile desselben aus elektrisch leitenden Fullerenen ( 2 ) gebildet ist.

3. Schaltungsplatte nach einem der vorhergehenden Ansprüche, dadurch gekennzeichnet,
daß durch Dotierung leitfähig gemachte Fullerene eingesetzt sind.

4. Schaltungsplatte nach einem der vorhergehenden Ansprüche, dadurch gekennzeichnet,
daß die Fullerene elektrolytisch aufgetragen sind.

5. Schaltungsplatte nach einem der vorhergehenden Ansprüche, dadurch gekennzeichnet,
daß die Fullerene auf die Kristallflächen eines Halbleiters, vorzugsweise Galliumarsenid, Gallium-Aluminiumarsenid, Aluminium-Galliumarsenid, Indiumphosphid oder Indiumgalliumarsenid, aufgewachsen sind.

6. Schaltungsplatte nach einem der vorhergehenden Ansprüche, dadurch gekennzeichnet,
daß das Schaltungsbild Widerstände, Kondensatoren, Dioden, Transistoren und/oder dergleichen elektrische Schaltungselemente ( 2, 4, 5, 6 ) integriert aufweist, die ganz oder teilweise durch leitfähige Fullerene gebildet sind.

7. Schaltungsplatte nach einem der vorhergehenden Ansprüche, dadurch gekennzeichnet,
daß die das Schaltungsbild bildenden Fullerene in ein oder mehreren monomolekularen Schichten ( 2 ) aufgetragen sind und
daß Zwischenschichten ( 3, 5 ) anderer Leitfähigkeit als die der Fulleren-Schicht ( 2 ) zwischen benachbarten Fulleren-Schichten ( 2, 4 ) vorgesehen sind.

8. Schaltungsplatte nach Anspruch 7, dadurch gekennzeichnet,
daß die Fulleren-Moleküle innerhalb der Schichten ( 2 ) gleichgroß aber entsprechend dem angestrebten Schaltungsbild unterschiedlich dotiert sind.

9. Schaltungsplatte nach einem der vorhergehenden Ansprüche, dadurch gekennzeichnet,
daß benachbart angeordnete, eine Gruppe bildende Fullerene hinsichtlich ihrer Dotierung mit gleicher sphärischer Orientierung aber gegenüber Fullerenen anderer Gruppen mit unterschiedlicher sphärischer Orientierung angeordnet sind.

10. Schaltungsplatte nach einem der vorhergehenden Ansprüche, dadurch gekennzeichnet,
daß Fullerene in mehrere Gruppen unterteilt sind,
daß die Fullerene der einzelnen Gruppen gemischt, ein Raster bildend angeordnet sind,
daß die Fullerene einer Gruppe unter sich gleichgroß, gleichdotiert und mit Bezug auf ihre Dotierung sphärisch gleich orientiert angeordnet sind und
daß die Fullerene unterschiedlicher Gruppen sich hinsichtlich Größe, Dotierung, sphärischer Anordnung und/oder ihrer Anordnung inverschiedenen Ebenen voneinander unterscheiden.
